# EUROPÄISCHE PATENTANMELDUNG

(11) **EP 1 881 503 A1**
(43) Veröffentlichungstag der Anmeldung: **23.01.2008**
(21) Anmeldenummer: 07012239.5
(22) Anmeldetag: 22.06.2007
(51) Int. Cl.: G11C 16/02, G11C 13/00

(54) **Verfahren und Speicherschaltung zum Betreiben einer Widerstandsspeicherzelle**

(30) Priorität: 21.07.2006 DE 102006033915; 21.07.2006 US 459289
(71) Anmelder: Qimonda AG, 81739 München (DE)
(72) Erfinder: Hönigschmid, Heinz, 82343 Pöcking (DE); Ivanov, Milena, 82008 Unterhaching (DE); Liaw, Corvin, 80335 München (DE); Müller, Gerhard, 81549 München (DE)
(74) Vertreter: Patentanwaltskanzlei WILHELM & BECK

(57) **Zusammenfassung**

Die Erfindung betrifft ein Verfahren zum Auslesen eines Speicherdatums aus einer Widerstandsspeicherzelle (2), die einen über eine Steuerungsgröße (S) ansteuerbaren Auswahltransistor aufweist, mit folgenden Schritten: Detektieren eines durch die Widerstandsspeicherzelle fließenden Zellenstroms, Einstellen der Steuerungsgröße abhängig von dem detektierten Zellenstrom, Bereitstellen einer der Steuerungsgröße zugeordneten Information als Speicherdatum.

## Beschreibung

Die Erfindung betrifft ein Verfahren zum Auslesen eines Speicherdatums aus einer Widerstandsspeicherzelle, insbesondere einer CBRAM-Speicherzelle (CBRAM: Conductive Bridging RAM). Die Erfindung betrifft weiterhin eine Speicherschaltung mit einer Widerstandsspeicherzelle.

In CBRAM-Speicherschaltungen wird eine Information in CBRAM-Speicherzellen gespeichert, die jeweils ein Widerstandsspeicherelement aufweisen. Das Widerstandsspeicherelement kann verschiedene Widerstandswerte annehmen, so dass durch Änderung des Widerstandswertes des Widerstandsspeicherelementes die zu speichernde Information festgelegt werden kann. Um den Inhalt der CBRAM-Speicherzelle zu bewerten, ist folglich eine Bewertung des Widerstandswertes des Widerstandsspeicherelementes der betreffenden Speicherzelle notwendig. Dies kann durch Anlegen einer Spannung und Messen des resultierenden durch die CBRAM-Speicherzelle fließenden Strom erfolgen. Um den Widerstandswert des Widerstandsspeicherelementes beim Auslesen der Information nicht zu verändern, dürfen die dazu an das Widerstandsspeicherelement angelegten Spannungen nicht außerhalb eines bestimmten Spannungsbereiches liegen, z.B. zwischen 100 und 200 mV. Dabei beträgt der Widerstandswert des Widerstandsspeicherelementes typischerweise zwischen 10⁴ bis 10⁹ Ω, so dass sich Ströme durch die Speicherzellen zwischen 100 pA und 10 µA ergeben. In der üblicherweise für CBRAM-Speicherschaltungen verwendeten Schaltungstechnik sind Ströme unter 1 µA jedoch nicht mehr auflösbar, so dass diese als 0 µA detektiert werden. Bei einem Single-Level-Design, d.h. bei einer binären Speicherung von Daten in den CBRAM-Widerstandsspeicherzellen würde ein potenzieller Ausleseverstärker den durch die Speicherzelle fließenden Strom mithilfe eines Referenzstroms von 5 µA bewerten, um zwischen zwei logischen Zuständen zu unterscheiden. Bei einem Multilevel-Design der CBRAM-Speicherschaltung wird der für CMOS-Schaltungstechnik bereits relativ geringe Signalstrom noch weiter auf die einzelnen Werte aufgeteilt. Bei einer Speicherung von 2 Bits/Speicherzelle betragen die Zellströme etwa 10 µA (Zustand "11"), 6,66 µA (Zustand "10"), 3,33 µA (Zustand "01") und 0 µA (Zustand "00"), was eine Auflösung des Signalstroms von mindestens 1,66 µA erfordert, die mit der herkömmlichen Schaltungstechnik nur aufwändig zu realisieren ist.

Es ist daher Aufgabe der vorliegenden Erfindung, ein Verfahren zum Auslesen eines Speicherdatums aus einer CBRAM-Speicherzelle zur Verfügung zu stellen, bei dem die zuvor genannten Nachteile vermieden werden, und wobei, insbesondere bei einem Multilevel-Design, das Detektieren des Zustands des Widerstandsspeicherelementes der CBRAM-Speicherschaltung zuverlässig durchgeführt werden kann. Es ist weiterhin Aufgabe der vorliegenden Erfindung, eine CBRAM-Speicherschaltung zur Verfügung zu stellen, bei der die Information aus CBRAM-Speicherzellen in verbesserter Weise ausgelesen werden kann.

Diese Aufgaben werden durch das Verfahren nach Anspruch 1 sowie die Speicherschaltung nach Anspruch 8 gelöst.

Weitere vorteilhafte Ausgestaltungen der Erfindung sind in den abhängigen Ansprüchen angegeben.

Gemäß einem ersten Aspekt der vorliegenden Erfindung ist ein Verfahren zum Auslesen eines Speicherdatums aus einer Widerstandsspeicherzelle vorgesehen, die einen über eine Steuerungsgröße ansteuerbaren Auswahltransistor aufweist. Das Verfahren umfasst die Schritte des Detektierens eines durch die Widerstandsspeicherzelle fließenden Zellenstroms, des Einstellens der Steuerungsgröße abhängig von dem detektierten Zellenstrom und des Bereitstellens einer der Steuerungsgröße zugeordneten Information als Speicherdatum.

Das erfindungsgemäße Verfahren hat den Vorteil, dass die den Auswahltransistor ansteuernde Steuerungsgröße, die abhängig von dem detektierten Zellenstrom eingestellt wird, die Information in der Widerstandsspeicherzelle bestimmt. Dazu wird insbesondere der durch die Widerstandsspeicherzelle fließende Zellenstrom mit einem Referenzstrom verglichen und die Steuerungsgröße abhängig von dem Ergebnis des Vergleichens eingestellt. Üblicherweise wird die Steuerungsgröße so eingestellt, dass der Zellenstrom möglichst dem Referenzstrom entspricht. Die unterschiedlichen Widerstandswerte des in der Widerstandsspeicherzelle befindlichen Widerstandsspeicherelementes führen zu unterschiedlichen Steuerungsgrößen des Auswahltransistors, wenn der Zellenstrom durch die Widerstandsspeicherzelle konstant gehalten werden soll. Mit der unterschiedlichen Gate-Spannung des Auswahltransistors bei verschiedenen Widerstandswerten des Widerstandsspeicherelementes kann eine einfache Bewertung des Zustands der Widerstandsspeicherzelle erfolgen, da sich aufgrund der unterschiedlichen Steigungen der Zellenstrom-Gate-Spannungskennlinie für die Widerstandsspeicherzelle abhängig von dem Widerstandswert des in der Widerstandsspeicherzelle angeordneten Widerstandsspeicherelementes leicht detektierbare Spannungsunterschiede ergeben.

Gemäß einer bevorzugten Ausführungsform wird eine Messgröße an den Auswahltransistor angelegt und solange verändert, bis ein Vorzeichen einer Differenz zwischen dem Zellenstrom und dem Referenzstrom wechselt, wobei die Messgröße, bei der das Vorzeichen der Differenz wechselt, als Steuerungsgröße eingestellt wird.

Vorzugsweise wird die Messgröße um diskrete Werte geändert.

Weiterhin kann die Messgröße aus einer Anzahl verschiedener Werte ausgewählt werden, wobei bei einem Wechsel des Vorzeichens einer Differenz zwischen dem Zellenstrom und dem Referenzstrom zwischen aufeinander folgend angelegte Messgrößen die zuletzt angelegte Messgröße als Steuerungsgröße eingestellt wird.

Insbesondere kann als Anzahl verschiedener Werte der Steuerungsgröße eine um 1 verminderte Anzahl detektierbarer Zustände der Widerstandsspeicherzelle gewählt werden.

Gemäß einem weiteren Aspekt der vorliegenden Erfindung ist eine Speicherschaltung zum Auslesen eines Speicherdatums mit einer Widerstandsspeicherzelle, die einen über eine Steuerungsgröße ansteuerbaren Auswahltransistor aufweist, vorgesehen. Die Speicherschaltung weist weiterhin eine Auswerteeinheit auf, um einen durch die Widerstandsspeicherzelle fließenden Zellenstrom zu detektieren, um die Steuerungsgröße abhängig von dem detektierten Zellenstrom einzustellen und um eine der Steuerungsgröße zugeordneten Information als Speicherdatum bereitzustellen.

Vorzugsweise umfasst die Auswerteeinheit eine Vergleichereinheit, um den durch die Widerstandsspeicherzelle fließenden Zellenstrom mit einem Referenzstrom zu vergleichen und eine Steuereinheit, um die Steuerungsgröße abhängig von dem Ergebnis des Vergleichens einzustellen.

Vorzugsweise ist die Steuereinheit ausgestaltet, um die Steuerungsgröße so einzustellen, dass der Zellenstrom möglichst dem Referenzstrom entspricht.

Die Steuereinheit kann eine Messschaltung aufweisen, um eine Messgröße an den Auswahltransistor anzulegen und diese solange zu verändern, bis die Vergleichereinheit feststellt, dass ein Vorzeichen einer Differenz zwischen dem Zellenstrom und dem Referenzstrom gewechselt hat, wobei die Messschaltung weiterhin ausgebildet ist, um die Messgröße, bei der das Vorzeichen der Differenz wechselt, als Steuerungsgröße einzustellen. Dabei kann die Messschaltung ausgebildet sein, um die Messgröße um diskrete Werte zu ändern.

Weiterhin kann vorgesehen sein, dass die Messschaltung die Messgröße aus einer Anzahl verschiedener Werte auswählt und bei einem Wechsel des Vorzeichens einer Differenz zwischen dem Zellenstrom und dem Referenzstrom zwischen aufeinander folgend angelegten Messgrößen die zuletzt angelegte Messgröße als Steuerungsgröße einstellt.

Bevorzugte Ausführungsformen der vorliegenden Erfindung werden nachfolgend anhand der beigefügten Zeichnungen näher erläutert. Es zeigen:
Fig. 1 eine schematische Darstellung einer CBRAM-Speicherschaltung mit einer CBRAM-Speicherzelle gemäß dem Stand der Technik;
Fig. 2 ein Blockschaltbild einer CBRAM-Speicherschaltung gemäß einer Ausführungsform der Erfindung;
Fig. 3 ein detaillierteres Schaltbild einer CBRAM-Speicherschaltung gemäß der Ausführungsform der Erfindung;
Fig. 4 eine Kennlinie des Zellenstroms über der Gate-Spannung bei verschiedenen Widerständen des Widerstandsspeicherelementes der betrachteten CBRAM-Speicherzelle; und
Fig. 5 eine detailliertere schematische Darstellung der Ausleseschaltung für die erfindungsgemäße CBRAM-Speicherschaltung; und
Fig. 6 eine schematische Darstellung einer Schreibschaltung für die CBRAM-Speicherschaltung.

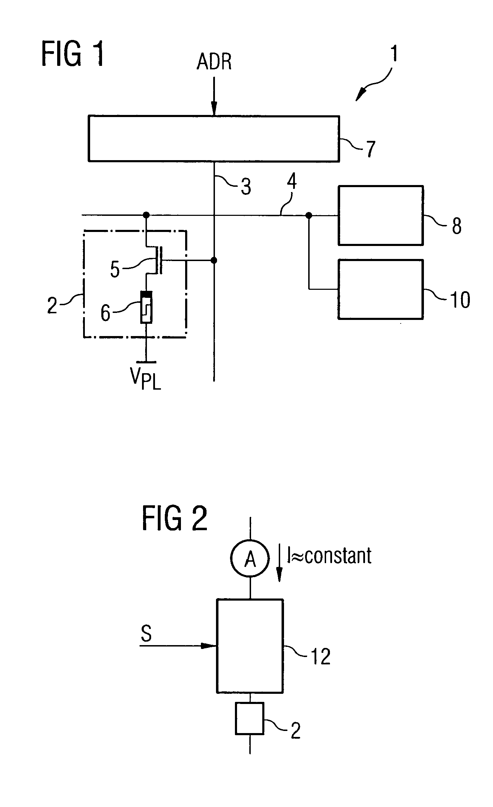

In Fig. 1 ist ein Ausschnitt aus einer herkömmlichen CBRAM-Speicherschaltung 1 dargestellt, wobei zur einfacheren Darstellung nur eine CBRAM-Speicherzelle 2 an einem Kreuzungspunkt einer Wortleitung 3 und einer Bitleitung 4 dargestellt ist. Die Speicherzelle 2 umfasst einen Auswahltransistor 5, der in Reihe mit einem Widerstandsspeicherelement 6 zwischen der Bitleitung und einem festgelegten Plattenpotenzial VPL geschaltet ist. Im Detail ist ein erster Anschluss des Auswahltransistors 5 mit der Bitleitung und ein zweiter Anschluss des Auswahltransistors 5 mit einem ersten Anschluss des Widerstandsspeicherelementes 6 verbunden. Ein zweiter Anschluss des Widerstandsspeicherelementes 6 ist mit dem Plattenpotenzial VPL verbunden. Ein Steueranschluss des Auswahltransistors 5 ist mit der Wortleitung 3 verbunden.

Das Widerstandsspeicherelement 6 ist als ein CBRAM-Widerstandsspeicherelement, auch PMC-Widerstandsspeicherelement (PMC: Programmable Metallization Cell) genannt u.ä., ausgebildet. Ein solches Widerstandsspeicherelement kann je nach Programmierzustand verschiedene Widerstandswerte aufweisen. Programmiert werden kann ein solches Widerstandselement 6 durch Anlegen einer Programmierspannung, wodurch das Widerstandsspeicherelement einen ersten niedrigen Widerstandswert einnimmt. Mithilfe einer Löschspannung, die eine der gegenüber Programmierspannung invertierte Polarität aufweist, kann das Widerstandsspeicherelement in einem Zustand mit einem hohen Widerstandswert versetzt werden. Das Programmieren und Löschen des Widerstandsspeicherelementes 6 erfolgt im Wesentlichen durch Ausbilden und Zurückbilden eines elektrisch leitenden Pfads aus einem in einen Festkörperelektrolyten migrierenden Material, z.B. Ag. Die Funktionsweise eines solchen Widerstandsspeicherelementes ist aus dem Stand der Technik hinlänglich bekannt und es wird hierin nicht weiter darauf eingegangen. Anstelle eines CBRAM-Widerstandsspeicherelementes können auch andere Widerstandsspeicherelemente, die verschiedene Zustände mit verschiedenen Widerstandswerten einnehmen können, in Verbindung mit den nachfolgend beschriebenen Ausführungsformen der erfindungsgemäßen CBRAM-Speicherschaltung verwendet werden.

Das Adressieren der Speicherzelle 2 erfolgt im Wesentlichen durch ein Aktivieren der Wortleitung, d.h. auf die Wortleitung wird ein Aktivierungssignal angelegt, wodurch der Auswahltransistor 5 geschlossen (leitend) wird, so dass die Bitleitung 4 über den Auswahltransistor 5 mit dem Widerstandsspeicherelement 6 verbunden wird. Das Auslesen erfolgt nun mithilfe einer Ausleseschaltung 8, die ein vorbestimmtes Potenzial auf die Bitleitung 4 anlegt und den über die Bitleitung 4 und durch das adressierte Widerstandsspeicherelement 6 fließenden Strom auswertet. Abhängig von der Höhe des Stroms wird der Widerstandszustand der Speicherzelle 2 bestimmt.

Das Auslesen einer Multibit-Speicherzelle, d.h. einer Speicherzelle, die mehr als zwei Zustände aufweisen kann, erfolgt im Wesentlichen auf gleiche Weise, wobei mit dem Anlegen der Auslesespannung auf die Bitleitung detektiert wird, in welchem Bereich sich der resultierende Strom durch die Speicherzelle befindet. Je nachdem, in welchem Bereich der Strom durch die Speicherzelle liegt, kann der Speicherzelle ein bestimmter Zustand zugeordnet werden und ein entsprechendes Datum ausgegeben werden.

Beschrieben wird die CBRAM-Speicherzelle 2 mit einer Programmierschaltung 10, bei der in der Regel über die Bitleitung durch die aktivierte Speicherzelle 2 ein vorbestimmter Programmierstrom mit einer von dem zu schreibenden Datum abhängigen Richtung angelegt wird, um das Widerstandselement 6 der Speicherzelle 2 in einen hochohmigen oder niederohmigen Zustand zu bringen. Bei einer Multilevel-Speicherzelle kann die Programmierschaltung 10 so gestaltet sein, dass der Widerstandswert des Widerstandsspeicherelementes in einen bestimmten Bereich gebracht wird, der einem bestimmten Zustand der CBRAM-Speicherzelle 2 entspricht. Der Programmierstrom wird mithilfe eines Stromspiegels in der Programmierschaltung an die Bitleitung angelegt, so dass sich an der Bitleitung ein Bitleitungspotenzial einstellt, wodurch das Widerstandselement 6 der Widerstandsspeicherzelle programmiert bzw. gelöscht wird.

Insbesondere beim Programmieren, d.h. bei einem Vorgang, bei dem das Widerstandsspeicherelement auf einen niederohmigen Zustand gebracht wird, kommt es aufgrund der Kapazität der Bitleitung zu einer Stromspitze, wenn die durch die Abnahme des Widerstandswertes Widerstandsspeicherelement 6 anwachsende Strom 6 aus der auf der Bitleitung gespeicherten Ladung bedient wird. Dieser erhöhte Strom durch das Widerstandsspeicherelement 6 übersteigt den durch die Programmierschaltung 10 bereitgestellten Strom wesentlich, und kann zu einer Beschädigung des Widerstandsspeicherelementes führen.

Das Detektieren des Stroms durch die Speicherzelle beim Auslesen ist insbesondere bei einer Multilevel-Speicherzelle schwierig, da die Ströme sehr gering sind, so dass diese nicht zuverlässig durch eine entsprechende Auswerteschaltung so genau detektiert werden können, dass ihnen ein bestimmter Zustand zugeordnet werden kann. Wie in Fig. 2 dargestellt ist, sieht das Konzept der Erfindung vor, den Zustand einer Speicherzelle auszulesen, wenn ein Strom I durch die Speicherzelle 2 mithilfe einer Regeleinheit 12 konstant geregelt wird. Die für die Regeleinheit dazu benötigte Steuerungsgröße S lässt sich einen Zustand der Speicherzelle 2 eindeutig zuordnen.

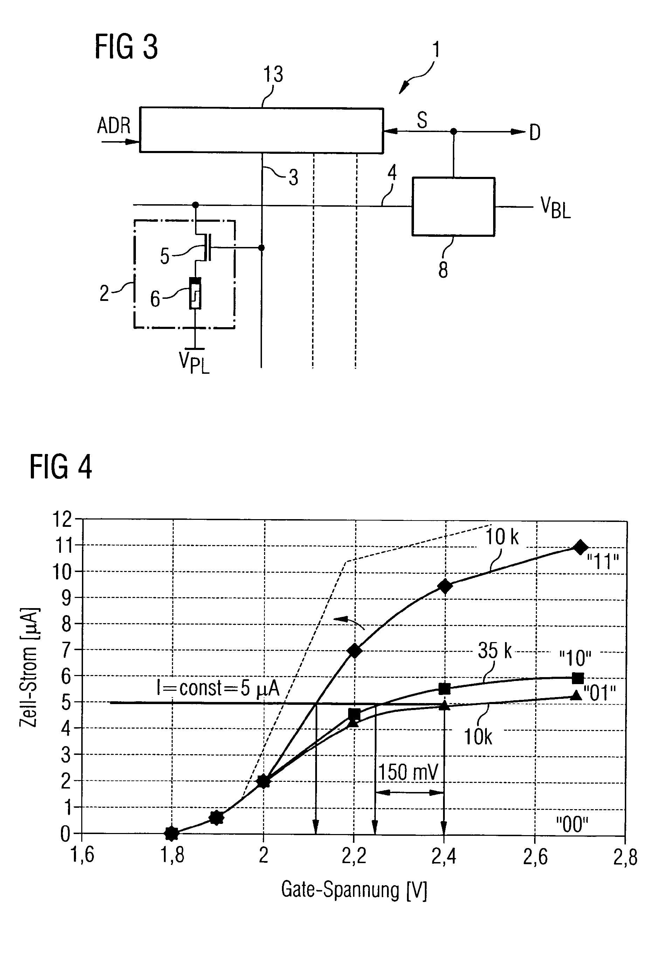

In Fig. 3 ist eine detailliertere Darstellung der erfindungsgemäßen Speicherschaltung gezeigt. Gleiche Bezugszeichen entsprechen Elementen gleicher oder vergleichbarer Funktionen. Mit der Speicherschaltung der Fig. 3 wird im Wesentlichen das Konzept verfolgt, den Auslesetransistor 5 als Teil einer Regelungsschaltung zu verwenden, wobei der Auslesetransistor nicht mehr entsprechend einer angelegten Wortleitungsadresse geschlossen oder geöffnet wird, sondern mit einem geeigneten analogen Aktivierungspotenzial auf der Wortleitung 3 so angesteuert wird, dass ein vorab festgelegter Strom durch die Speicherzelle 2 fließt. Dies wird dadurch erreicht, dass die Ausleseschaltung 8 ein festgelegtes Bitleitungspotenzial VBL an die Bitleitung 4 anlegt und die Steuerungsgröße S an die zu adressierende Wortleitung 3 anlegt. Das Anlegen erfolgt mithilfe eines Wortleitungsdecoders 13, der das Steuerungspotenzial an die abhängig von einer angelegten Wortleitungsadresse ADR zu aktivierende Wortleitung 3 anlegt und die übrigen Wortleitungen mit einem Potenzial, z.B. dem Plattenpotenzial VPL oder einem Massepotential, ansteuert, so dass die jeweiligen Auswahltransistoren 5 vollständig geöffnet nicht leitend) sind. Die Steuerungsgröße S ist im eingeregelten Zustand, d.h. wenn der vorbestimmte Strom über die Bitleitung 4 und durch die Speicherzelle 2 fließt, einem aus der Speicherzelle 2 auszulesenden Datum D, zuordbar. Die Steuerungsgröße S entspricht einem jeweiligen Potenzial, das aufgrund der Übertragungskennlinie des Auswahltransistors 5 in der Speicherzelle 2 für die verschiedenen Widerstandszustände des Widerstandsspeicherelementes 6 einen ausreichenden Potenzialabstand aufweist.

In Fig. 4 sind beispielhaft Kennlinien einer beispielhaften Speicherzelle mit vier verschiedenen Zuständen des Widerstandselementes 6 dargestellt. Die verschiedenen Widerstandswerte der Zustände betragen 10 kΩ, 35 kΩ, 50 kΩ und 1 MΩ. Man erkennt, dass bei einem konstanten Strom von 5 µA durch die Speicherzelle in einem ersten Zustand, bei dem das Widerstandselement einen Widerstandswert von 10 kΩ aufweist, das Steuerungspotenzial, das an den Auswahltransistor 5 angelegt wird, 2,1 V beträgt, in einem zweiten Zustand, bei dem der Widerstandswert des Widerstandselementes 35 kΩ beträgt, das Steuerungspotenzial 2,25 V beträgt, in einem dritten Zustand, bei dem der Widerstandswert des Widerstandselementes 6 50 kΩ beträgt, das Steuerungspotenzial 2,4 V beträgt und das in einem vierten Zustand, bei dem das Widerstandselement hochohmig 1 MΩ. ist, so dass bei üblicherweise in der Speicherschaltung verwendeten Spannungen der konstante Strom von 5 µA nicht erreichbar ist und daher im Wesentlichen 0 µA beträgt.

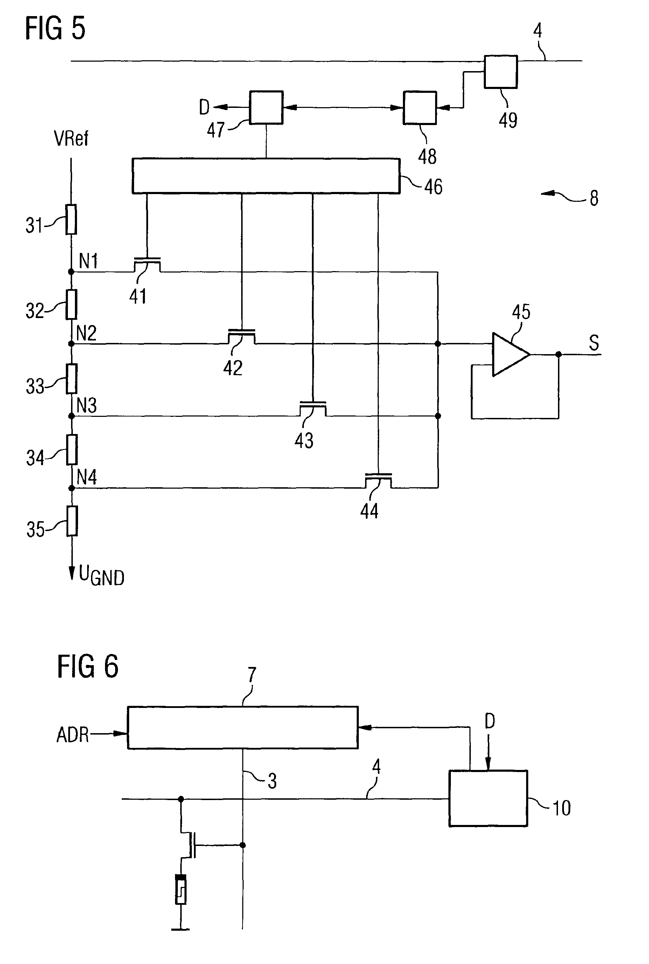

In Fig. 5 ist die Ausleseschaltung 8 detaillierter dargestellt. Die Ausleseschaltung 8 generiert eine Steuerungsgröße S durch das geeignete Abgreifen eines Potenzials aus einem Spannungsteiler, der mit mehreren Widerständen 31 bis 35 ausgebildet ist. Der erste bis fünfte Widerstand 31 bis 35 sind in Reihe zwischen einem Referenzpotenzial und einem Massepotenzial V_{GND} geschaltet. Ein erster Knoten N1 zwischen dem ersten Widerstand 31 und dem zweiten Widerstand 32 ist über einen ersten Transistor 41, ein zweiter Knoten N2 zwischen dem zweiten Widerstand 32 und dem dritten Widerstand 33 ist über einen zweiten Transistor 42, ein dritter Knoten N3 zwischen dem dritten Widerstand 33 und dem vierten Widerstand 34 ist über einen dritten Transistor 43 und ein vierter Knoten N4 zwischen dem vierten Widerstand 34 und dem fünften Widerstand 35 ist über einen vierten Transistor 44 mit einem Eingang eines Treibers 45 verbunden. Ein Ausgangstreiber 45 ist im Wesentlichen als ein rückgekoppelter Operationsverstärker ausgebildet, der die in dem ersten Eingang anliegende Spannung, die von den Transistoren 41-44 geliefert wird, als Steuerungsgröße S ausgibt. Steueranschlüsse der Transistoren 41 bis 44 sind jeweils mit einem Decoder 46 verbunden, der abhängig von einem Zählerwert eines Zählers 47 jeweils einen der Transistoren 41 bis 44 schließt und die jeweils anderen Transistoren in einen geöffneten Zustand bringt oder belässt. Mithilfe einer Steuereinheit 48 wird ein Auslesevorgang gestartet, indem der Zähler 47 hochgezählt wird, so dass nacheinander jeder der Transistoren 41 bis 44 geschlossen wird.

Die Bitleitung 4 ist über einen Stromdetektor 49 mit einer Spannungsquelle so verbunden, die z.B. ein Potenzial in Höhe einer Versorgungsspannung bereitstellt. Der Stromdetektor 49 detektiert den über die Bitleitung 4 fließenden Strom abhängig von einer Referenzgröße (Referenzstrom I_{REF}) und gibt ein entsprechendes Vergleichssignal aus.

Das Hochzählen des Zählers 47 wird gestoppt, wenn, festgestellt durch den Stromdetektor 49, Strom auf der Bitleitung 4 den vorbestimmten Strom über- bzw. unterschreitet, je nachdem, ob die an den Auswahltransistor angelegte Spannung durch das Nacheinanderschalten der Transistor en 41 bis 44 ansteigt oder sinkt. Wenn der Strom über die Bitleitung 4 den vorbestimmten Strom erreicht bzw. über- oder unterschreitet, wird der aktuelle Zählerstand 47 als Datum D ausgegeben.

Im vorliegenden Fall kann die Ausleseschaltung 8 der Fig. 5 zum Auslesen von vier verschiedenen Zuständen dienen, so dass der Zähler 47 als 2-Bit-Zähler vorgesehen werden kann. Es ist dann möglich, eine Multibit-Speicherschaltung zu realisieren, bei denen in jeder Speicherzelle 2 Bit gespeichert werden können. Bei einer Konfiguration, die zu einem elektrischen Verhalten gemäß der Kennlinie der Fig. 3 führt, lassen sich in einfacher Weise die entsprechenden Spannungen mithilfe des Spannungsteilers aus den Widerständen 31 bis 35 generieren. Zum Auswerten der Multibit-Speicherzelle, die der Kennlinie der Fig. 4 entspricht, sollten dann Spannungen an den Knoten N1 bis N4 bereitgestellt werden, die die Grenzen der verschiedenen Zustandsbereiche, die die Speicherzelle einnehmen können, definieren. Im gezeigten Beispiel könnten dies die Spannungen von 2,175, 2,325 und 2,6 V sein. In diesem Fall könnte zum Auslesen von vier verschiedenen Zuständen aus der Multibit-Speicherzelle auch nur drei Auslesespannungen an drei Knoten N1 bis N3 zur Verfügung gestellt werden, um vier Zustände der Multibit-Speicherzelle zu detektieren.

In Fig. 6 ist eine Speicherschaltung gemäß einer weiteren Ausführungsform gezeigt, bei der eine Steuerungsgröße über den Wortleitungsdecoder 7 an die adressierte Wortleitung 3 angelegt wird, um die Speicherzelle so zu beschreiben, dass ein Spitzenstrom, der beim Übergang von einem hohen auf einen niedrigen Widerstandswert des Widerstandselementes auftreten kann, begrenzt. Dazu stellt die Programmierschaltung 10 eine Programmierspannung bereit, mit der das Widerstandselement der adressierten Speicherzelle von einem hochohmigen auf einen niederohmigen Zustand gebracht werden kann. Im Gegensatz zu bisherigen CBRAM-Speicherschaltungen wird nun die Wortleitung 3 so aktiviert, dass der Auswahltransistor das Widerstandselement 6 mit der Bitleitung verbindet, so dass ein Programmiervorgang gestartet wird. Sinkt der Widerstandswert des Widerstandselementes 6, so erhöht sich der Strom durch die Speicherzelle, was durch die Programmierschaltung 10 z.B. mit Hilfe des Stromdetektors 49 durch den Stromfluss über die Bitleitung 4 detektiert werden kann. Übersteigt der Stromfluss durch die Speicherzelle einen Grenzwert, so wird über den Wortleitungsdecoder 7 auf der Wortleitung 3 das Potenzial der Steuerungsgröße reduziert, so dass der Durchgangswiderstand des Auswahltransistors 5 erhöht wird, wodurch der Strom begrenzt werden kann. Auf diese Weise lässt sich der Strom durch das Widerstandsspeicherelement der Speicherzelle 2 begrenzen, so dass eine Beschädigung der Speicherzelle 2 vermieden werden kann.

## Patentansprüche

1. Verfahren zum Auslesen eines Speicherdatums aus einer Widerstandsspeicherzelle (2), die einen über eine Steuerungsgröße ansteuerbaren Auswahltransistor aufweist, mit folgenden Schritten:
- Detektieren eines durch die Widerstandsspeicherzelle fließenden Zellenstroms;
- Einstellen der Steuerungsgröße abhängig von dem detektierten Zellenstrom.

2. Verfahren nach Anspruch 1, wobei der durch die Widerstandsspeicherzelle (2) fließende Zellenstrom mit einem Referenzstrom verglichen wird, und wobei die Steuerungsgröße abhängig von dem Ergebnis des Vergleichens eingestellt wird.

3. Verfahren nach Anspruch 2, wobei die Steuerungsgröße so eingestellt wird, dass der Zellenstrom möglichst dem Referenzstrom entspricht.

4. Verfahren nach Anspruch 2 oder 3, wobei eine Meßgröße an den Auswahltransistor (5) angelegt wird und solange verändert wird, bis ein Vorzeichen einer Differenz zwischen dem Zellenstrom und dem Referenzstrom wechselt, wobei die Meßgröße, bei der das Vorzeichen der Differenz wechselt, als Steuerungsgröße eingestellt wird.

5. Verfahren nach Anspruch 4, wobei die Meßgröße um diskrete Werte geändert wird.

6. Verfahren nach einem der Ansprüche 4 oder 5, wobei die Meßgröße aus einer Anzahl verschiedener Werte ausgewählt wird, wobei bei einem Wechsel des Vorzeichens einer Differenz zwischen dem Zellenstrom und dem Referenzstrom zwischen aufeinander folgend angelegten Meßgrößen die zuletzt angelegte Meßgröße als Steuerungsgröße eingestellt wird.

7. Verfahren nach Anspruch 6, wobei die Anzahl verschiedener Werte der Steuerungsgröße einer um eins verminderten Anzahl detektierbarer Zustände der Widerstandsspeicherzelle gewählt wird.

8. Speicherschaltung (1) zum Auslesen eines Speicherdatums mit einer Widerstandsspeicherzelle (2), die einen über eine Steuerungsgröße ansteuerbaren Auswahltransistor aufweist,
und mit einer Ausleseeinheit (8), um einen durch die Widerstandsspeicherzelle fließenden Zellenstrom zu detektieren, um die die Steuerungsgröße (S) abhängig von dem detektierten Zellenstrom einzustellen und um eine der Steuerungsgröße zugeordneten Information als Speicherdatum bereitzustellen.

9. Speicherschaltung nach Anspruch 8, wobei die Ausleseeinheit (8) umfasst:
- einen Stromdetektor (49), um den durch die Widerstandsspeicherzelle (2) fließenden Zellenstrom mit einem Referenzstrom zu vergleichen, und
- eine Steuereinheit, um die Steuerungsgröße abhängig von dem Ergebnis des Vergleichens einzustellen.

10. Speicherschaltung nach Anspruch 9, wobei die Steuereinheit (48) ausgestaltet ist, um die Steuerungsgröße so einzustellen, dass der Zellenstrom möglichst dem Referenzstrom entspricht.

11. Speicherschaltung nach Anspruch 9 oder 10, wobei die Steuereinheit (48) eine Messschaltung (41-44, 45) aufweist, um eine Meßgröße an den Auswahltransistor (5) anzulegen und diese solange zu verändern, bis die Vergleichereinheit feststellt, dass ein Vorzeichen einer Differenz zwischen dem Zellenstrom und dem Referenzstrom gewechselt hat, wobei die Steuereinheit (48) weiterhin ausgebildet ist, um die Meßgröße, bei der das Vorzeichen der Differenz wechselt, als Steuerungsgröße einzustellen.

12. Speicherschaltung (1) nach Anspruch 11, wobei die Messschaltung ausgebildet ist, um die Meßgröße um diskrete Werte zu ändern.

13. Speicherschaltung (1) nach einem der Ansprüche 11 oder 12, wobei die Messschaltung ausgestaltet ist, um die Meßgröße aus einer Anzahl verschiedener Werte auszuwählen, und wobei die Steuereinheit (48) bei einem Wechsel des Vorzeichens einer Differenz zwischen dem Zellenstrom und dem Referenzstrom I_{REF} zwischen aufeinander folgend angelegten Meßgrößen die zuletzt angelegte Meßgröße als Steuerungsgröße einstellt.

14. Speicherschaltung (1) nach Anspruch 13, wobei die Anzahl verschiedener Werte der Steuerungsgröße einer um eins verminderten Anzahl detektierbarer Zustände der Widerstandsspeicherzelle (2) gewählt ist.
